# EUROPEAN PATENT APPLICATION

(11) **EP 2 104 237 A2**
(43) Date of publication of application: **23.09.2009**
(21) Application number: 08253210.2
(22) Date of filing: 02.10.2008
(51) Int. Cl.: H04B 1/16

(54) **Receiving apparatus and method of making channel list in receiving apparatus**

(30) Priority: 19.03.2008 JP 2008070583
(71) Applicant: Hitachi, Ltd., Chiyoda-ku Tokyo 100-8220 (JP)
(72) Inventor: Hoda, Isao, Chiyoda-ku, Tokyo 100-8220 (JP)
(74) Representative: Calderbank, Thomas Roger

(57) **Abstract**

A receiving apparatus (1) having a first receiver (2, 11a) for frequency-converting a received signal, a second receiver (3, 11b) for frequency-converting the received signal, and a controller (17) that controls so as to switch a parameter for converting a corresponding frequency, depending on when the first receiver (2, 11a) and the second receiver (3, 11b) commonly received a signal having a first frequency, respectively, and when the receivers ((2, 11a), (3, 11b)) commonly received a signal having a second frequency, respectively, whereby even under environment where there is an adjacent channel interference in the receiving apparatus (1) with a plurality of tuners ((2, 11a), (3, 11b)), an influence of the interfering wave can be suppressed and the optimum receiving condition can be maintained.

## Description

The technical field of the present invention relates to a receiving apparatus with a plurality of tuners, and a method of controlling the same.

In recent years, the transition to the digital system from the analog system in television broadcasting has been promoted globally, and digital terrestrial broadcasting has been started in each country. In the digital terrestrial broadcasting system in Japan, an orthogonal frequency division multiplex (OFDM) system is used, and is operated as the ISDB-T (Integrated Service Digital Broadcasting Terrestrial) standard. On the other hand, also in the digital terrestrial broadcasting system in Europe, the OFDM system is used, and is operated as the DVB-T (Digital Video Broadcasting-Terrestrial) standard.

This OFDM system is a system, in which a large number of orthogonal subcarriers are provided within a transmission band, and the respective subcarriers are digitally modulated by quadrature amplitude modulation (QAM) or the like. Moreover, the OFDM-based digital broadcasting signal typically contains a continual pilot (hereinafter, referred to as CP) signal and a scattered pilot (hereinafter, referred to as SP) signal. These CP signal and SP signal are arranged in a plurality of subcarriers in a transmission band, and the carrier position of the arranged subcarrier is specified by the DVB-T standard (e.g., see "Digital Video Broadcasting (DVB); Framing structure, channel coding and modulation for digital terrestrial television "ETSI EN 300 744 V1.5.1 (2004-06)).

As the method for calculating a carrier frequency error in the OFDM-based digital broadcasting signal by using these CP signal and SP signal, there is disclosed a technique, in which an OFDM frequency domain signal after being subjected to Fast Fourier Transform (FFT) is converted into angular data, and subsequently, the CP signal is extracted by carrying out two times of difference detection, between symbols existing temporally before and after, with respect to this angular data, and then from the extracted CP signal, the degree of shift of the subcarrier position from the original subcarrier position is calculated, thereby calculating the broadband carrier frequency error of the OFDM signal (e.g., see JP-A-2001-308821).

Incidentally, in the digital broadcast receiving apparatus of recent years, receiving apparatuses that mount therein a plurality of tuners for each transmission medium have come on the market. The examples thereof include the one that mounts therein two digital satellite broadcasting tuners, the one that mounts therein two digital terrestrial broadcasting tuners, and the like. In such a receiving apparatus with a plurality of tuners, when the plurality of tuners select the same physical channel, a signal generated by a local oscillator used in the tuner may interfere with each other, resulting in degradation of the purity of the local oscillation frequency.

There is also disclosed a technique, in which when the same physical channel is selected in such a receiving apparatus with a plurality of tuners, the local oscillation frequency of a PLL circuit is shifted so that a significant local degradation in the equivalent C/N may not occur even if a mutual interference occurred, thereby reducing the mutual interference between each local oscillator and preventing degradation of the purity of the local oscillation frequency (e.g., see JP-A-2006-173922).

In the terrestrial broadcasting, especially near a boundary between broadcasting areas, an analog broadcasting signal and a digital broadcasting signal may be being transmitted to an adjacent physical channel. Under such environment, in a broadcast receiving apparatus, to which a prior art such as the one in JP-A-2006-173922 is applied, if the oscillation frequency of a local oscillator is shifted when there is an interfering wave in the adjacent channel, then there is a problem that this oscillation frequency will contain the interfering wave of the adjacent channel to degrade the receiver performance.

Then, the present invention provides, for example, a receiving apparatus with a plurality of tuners and a method of controlling the same that can suppress the influence of an interfering wave and the degradation of the receiving condition even under environment where an analog broadcasting signal and a digital broadcasting signal is being transmitted to an adjacent physical channel in the receiving apparatus with a plurality of tuners.

According to the present invention, there is provided a receiving apparatus, comprising: a first receiver for frequency-converting a received signal; a second receiver for frequency-converting the received signal; and a controller that controls so as to switch a parameter for converting a corresponding frequency, depending on when the first receiver and the second receiver commonly received a signal having a first frequency, respectively, and when these receivers commonly received a signal having a second frequency, respectively.

According to the present invention, for example, even under environment where an analog broadcasting signal and a digital broadcasting signal are being transmitted to an adjacent physical channel, in a receiving apparatus with a plurality of tuners, the influence of the interfering wave can be suppressed and the degradation of the receiving condition can be suppressed.

### IN THE DRAWINGS:

FIG. 1 shows a configuration example of a digital terrestrial broadcast receiving apparatus.
FIG. 2 shows a configuration example of a demodulator of the digital terrestrial broadcast receiving apparatus.
FIG. 3 shows a process example in carrying out automatic channel list preparation about physical channel arrangement specified in the digital terrestrial broadcasting.
FIG. 4 shows an example of a relationship between a physical channel number "N", and a center frequency as well as a channel bandwidth of the digital terrestrial broadcasting.
FIG. 5 shows an example of a method of calculating a carrier frequency offset amount from a frequency error.
FIG. 6 shows an example of a tuning process in carrying out tuning for the first time after channel scan is completed.
FIG. 7 shows a process example when the second receiver tunes while the first receiver is currently tuning in a certain physical channel.

An example (practical example) of a suitable embodiment for implementing the present invention will be described. However, the present invention is not limited to this embodiment.

In this embodiment, as a digital terrestrial broadcasting system, the DVB-T standard which is the digital terrestrial broadcasting system in the European region is described as an example. In the digital terrestrial broadcasting in the European region, primarily for the purpose of reducing an interference from an existing analog broadcasting that is arranged in an adjacent channel, it is possible to transmit with an offset from a center frequency of a channel bandwidth. This frequency offset amount is selected out of "without offset", "+1/6 MHz", "-1/6 MHz", "+2/6 MHz", "-2/6 MHz", "+3/6 MHz", and "-3/6 MHz" by the transmission side. In the actual operation, "without offset", "+1/6 MHz", and "-1/6 MHz" are widely used.

Hereinafter, the embodiment will be described in detail with reference to the accompanying drawings. Note that, in the drawings, like reference numerals refer to the same or equivalent parts.

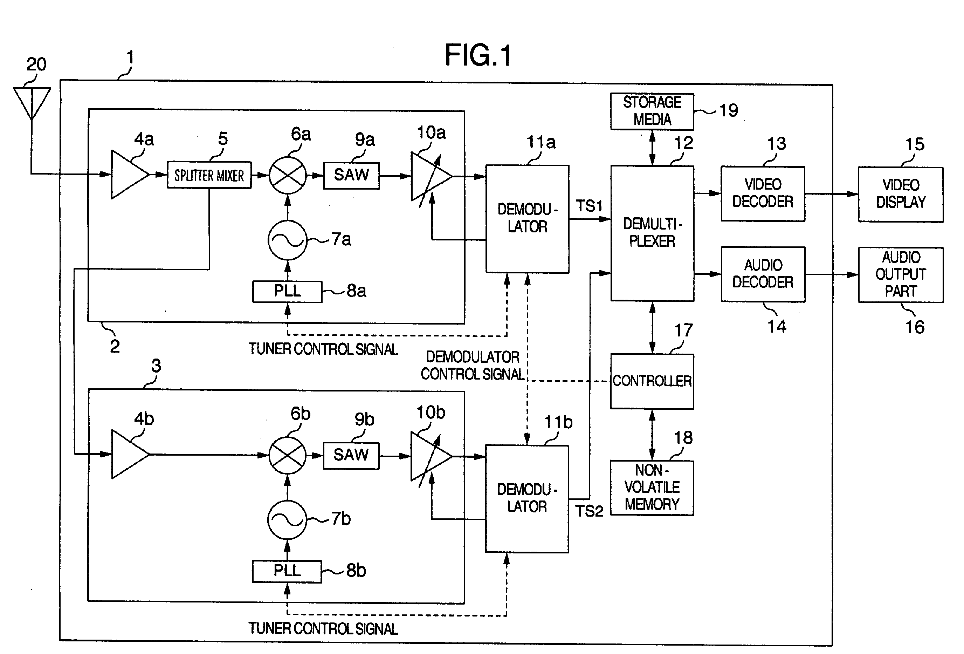

FIG. 1 is a block diagram showing a schematic example of a digital terrestrial broadcast receiving apparatus. In FIG. 1, a digital terrestrial broadcast receiving apparatus 1 comprises, a first tuner 2 as well as a second tuner 3, wide band amplifiers 4a and 4b, a splitter 5, mixer circuits 6a and 6b, local oscillators 7a and 7b, PLL (Phase Locked Loop) circuits 8a and 8b, SAW (Surface Acoustic Wave) filters 9a and 9b, AGC (Automatic Gain Control) amplifiers 10a and 10b, demodulators 11a and 11b, a demultiplexer 12, a video decoder 13, an audio decoder 14, a controller 17, a nonvolatile memory 18, and storage media 19. Moreover, in FIG. 1, in the configurations of the first tuner 2 and the second tuner 3, although, for convenience of description, suffixes "a" and "b" are given to discriminate between the configurations, a block given the same number shall carry out the same operation. The splitter 5 may be present in either of the tuner 2 and the tuner 3. Moreover, the signals may be input independently without the splitter, respectively.

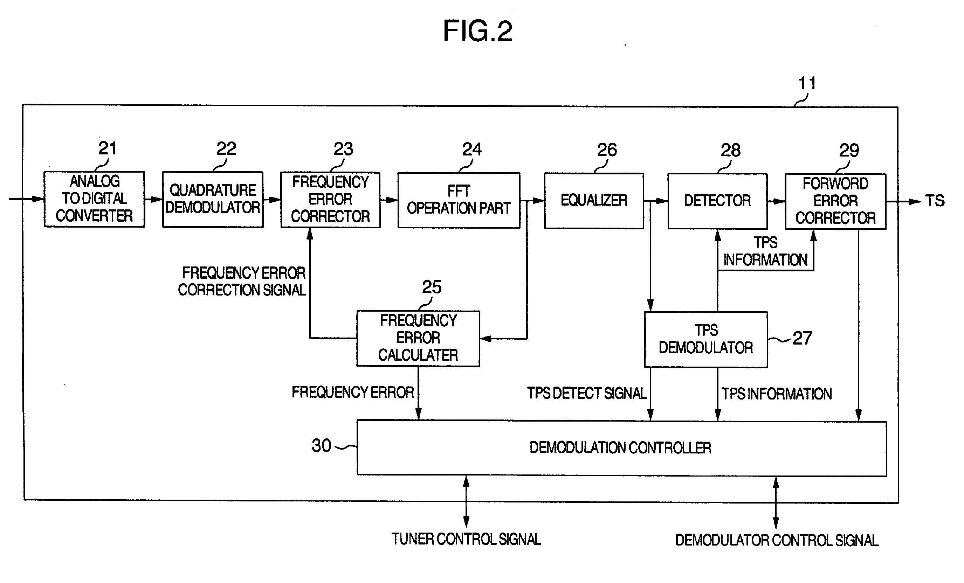

FIG. 2 is a block diagram for illustrating an operation example in the demodulator 11a and the demodulator 11b of the digital terrestrial broadcast receiving apparatus. In FIG. 2, the demodulator 11 comprises an analog to digital converter 21, a quadrature demodulator 22, a frequency error corrector 23, an FFT operation part 24, a frequency error calculator 25, an equalizer 26, a TPS (Transmission Parameter Signaling) demodulator 27, a detector 28, a forward error corrector 29, and a demodulation controller 30.

In the digital terrestrial broadcast receiving apparatus 1, an RF signal, which is a signal received at a receiving antenna 20, the RF signal being, for example, a digital terrestrial broadcasting signal transmitted from a broadcasting station, is supplied as an input to the digital terrestrial broadcast receiving apparatus 1.

The RF (Radio Frequency, high frequency) signal supplied as the input to the digital terrestrial broadcast receiving apparatus 1 is supplied to the first tuner 2. The RF signal supplied to the first tuner 2 is supplied to the wide band amplifier 4a. The wide band amplifier 4a amplifies the supplied RF signal, and supplies this amplified signal to the splitter 5. The RF signal supplied to the splitter 5 is split into two, which are then supplied to the mixer circuit 6a and the second tuner 3, respectively. The RF signal supplied to the mixer circuit 6a is frequency-converted into an IF (Intermediate Frequency) signal by being multiplied by a local oscillation signal that is generated by the local oscillator 7a, and then the IF signal is supplied to the SAW filter 9a. The local oscillation frequency of the local oscillation signal generated by the local oscillator 7a is controlled by a control voltage output from the PLL circuit 8a. Moreover, the local oscillation frequency shall be set discontinuously on the frequency axis, and is assumed to be set at a 1/6 MHz step in the digital terrestrial broadcast receiving apparatus of this embodiment. Hereinafter, this frequency step is defined as fₛₜₑₚ = 1/6 MHz.

The IF signal supplied to the SAW filter 9a is band-limited, and is supplied to the AGC amplifier 10a. Here, although not illustrated in FIG. 1, the pass bandwidth of the SAW filter 9a has, for example, characteristics of a plurality of passbands, such as 7 MHz and 8 MHz, and can be controlled by the control data to PLL 8a. The IF signal supplied to the AGC amplifier 10a is amplified so as to be appropriate as the input level to the demodulator 11a, and is then supplied to the demodulator 11a.

The IF signal supplied to the demodulator 11a is supplied to the analog to digital converter 21 inside the demodulator 11a. The analog to digital converter 21 converts the supplied IF signal into a digital signal, and supplies this output to the quadrature demodulator 22. The quadrature demodulator 22 quadrature demodulates the supplied digital signal into a baseband signal containing an I signal portion having a real-axis component and a Q signal portion having an imaginary-axis component by using a carrier signal having a specified frequency, and then supplies this output to the frequency error corrector 23.

The frequency error corrector 23 multiplies the supplied baseband signal by a frequency error correction signal generated by the frequency error calculator 25 to correct the frequency error, and then supplied the frequency-error corrected baseband signal to the FFT operation part 24. The FFT operation part 24 performs FFT processing to the effective symbol period of supplied baseband signal to convert the supplied baseband signal into a frequency domain signal corresponding to the subcarrier, and then supplies this output to the frequency error calculator 25 and the equalizer 26.

The frequency error calculator 25 intersymbol-differential-detects the supplied frequency domain signal. Thereby, from the correlation between the arrangement information of a subcarrier over which a CP signal contained in the frequency domain signal, the frequency domain signal being supplied to the frequency error calculator 25, is being transmitted, and the arrangement information of a subcarrier over which a CP signal specified by the DVB-T standard is being transmitted, the frequency error calculator 25 calculates a carrier frequency error and generates a frequency error correction signal. The frequency error correction signal generated by the frequency error calculator 25 is supplied to the frequency error corrector 23. Moreover, the frequency error value calculated by the frequency error calculator 25 is supplied to the demodulation controller 30. The frequency error range that can be corrected by the frequency error corrector 23 and the frequency error calculator 25 is preferably a value sufficiently larger than the frequency offset amount used in the digital terrestrial broadcasting. In the digital terrestrial broadcast receiving apparatus according to the embodiment of the present invention, it is assumed that if the center frequency of the digital terrestrial broadcasting signal of the RF signal is higher than the frequency tuned in the first tuner 2, the frequency error value is calculated as a positive one, while if the center frequency of the digital terrestrial broadcasting signal of the RF signal is lower than the frequency tuned in the first tuner 2, the frequency error value is calculated as a negative one.

The equalizer 26 performs equalization processing to the frequency domain signal using the SP signal, and supplies this output to the TPS demodulator 27 and the detector 28. The TPS demodulator 27 demodulates a TPS (Transmission Parameter Signaling) signal that is being transmitted over a specified subcarrier. The TPS signal contains, for example, the transmission control information specified by the DVB-T standard, such as the modulation method of the subcarrier, and the coding rate of the Viterbi code. Hereinafter, it is assumed that the transmission control information obtained by the TPS demodulator 27 is the TPS information.

The TPS signal demodulated in the TPS demodulator 27 is supplied to the detector 28, the forward error corrector 29, and the demodulation controller 30. Moreover, the TPS signal is decoded in the TPS demodulator 27, and a TPS detect signal indicating whether or not the TPS demodulator 27 has been able to detect the TPS information is supplied to the demodulation controller 30. The value of the TPS detect signal is set to "0" if the TPS demodulator 27 has been able to detect the TPS information, or is set to "1" if it has not been able to detect the TPS information yet. Note that, if the TPS detect signal is "1", it can be determined that a digital broadcasting signal is contained in the physical channel that has been tuned in the first tuner 2.

The detector 28, based on the TPS information supplied from the TPS demodulator 27, detects the frequency domain signal, which has been equalized by the equalizer 26, in accordance with the modulation method for each subcarrier, and then decodes data by demapping the detected signal. The data decoded in the detector 28 is supplied to the forward error corrector 29. Moreover, although not shown in the view, the detector 28 detects signal quality information on the supplied frequency domain signal, and supplies this quality information to the demodulation controller 30. Therefore, the demodulation controller 30 can be called "the signal quality acquisition part".

Here, the signal quality information includes a carrier to noise ratio (CNR), a signal to noise ratio (SNR), a modulation error ratio (MER), and the like, but not limited thereto in the digital terrestrial broadcast receiving apparatus according to the present invention. Note that, if the signal quality information is no less than a specified value, it can be determined that the physical channel that is tuned in the first tuner 2 is contained in the digital broadcasting signal.

The forward error corrector 29, based on the TPS information supplied from the TPS demodulator 27, performs error correction processing to the supplied data, for example, in accordance with the information, such as the coding rate of the Viterbi code, and outputs an MPEG-2 transport stream (hereinafter, referred to as TS). The TS output from the forward error corrector 29 is supplied to the demultiplexer 12. Moreover, the forward error corrector 29 detects a header byte (47 HEX) of the TS signal, for example, in the Reed-Solomon error correction, and thereby supplies an error correction lock signal indicating whether or not the error correction processing is synchronized, and a bit error rate (BER) after Viterbi decoding in Viterbi decoding process or a packet error rate (PER) after RS decoding in the RS decoding process, to the demodulation controller 30.

The value of the error correction lock signal is set to "1" if the error correction processing is synchronized in the forward error corrector 29, while it is set to "0" if not synchronized. Note that, if the error correction lock signal is "1" or the bit error rate in the error correction processing is no more than a specified value, it can be determined that a digital broadcasting signal is contained in the physical channel that is tuned in the first tuner 2

The demodulation controller 30 controls the analog to digital converter 21, the quadrature demodulator 22, the frequency error corrector 23, the FFT operation part 24, the frequency error calculator 25, the equalizer 26, the TPS demodulator 27, the detector 28, and the forward error corrector 29. Moreover, the demodulation controller 30 supplies the frequency error value supplied from the frequency error calculator 25, the TPS information and TPS detect signal supplied from the TPS demodulator 27, the signal quality information supplied from the detector 28, the error correction lock signal supplied from the forward error corrector 29, and the bit error rate after Viterbi decoding or the packet error rate after RS decoding, to the controller 17 via a control bus.

This control bus will supply each information in response to a request from the controller 17 by, for example, serial communication, such as an I2C (Inter-Integrated Circuit) bus, but not limited thereto in the digital terrestrial broadcast receiving apparatus according to the present invention. Moreover, the TPS detect signal may be supplied to the controller 17, as a hardware interrupt, without going through the control bus.

Furthermore, the demodulation controller 30, under the control (demodulator control signal) from the controller 17, transmits control data (tuner control signal) to the PLL circuit 8a to set both of or either of the local oscillation frequency of the local oscillation signal generated in the local oscillator 7a and the pass bandwidth of the SAW filter 9a. Here, a direct control from the controller 17 without going through the demodulation controller 30 may be contemplated. However, it is more efficient to extract only control data (tuner control signal) to be sent to the tuner in the demodulator and send this extracted data, rather than sending all of the demodulator control signals and the tuner control signals from the controller 17 to the tuner, and in the former case the degradation of the purity of the local oscillation signal generated in the local oscillator can be prevented.

On the other hand, the RF signal supplied to the second tuner 3 is supplied to the wide band amplifier 4b. The wide band amplifier 4b amplifies the supplied RF signal, and supplies the amplified RF signal to the mixer circuit 6b. The mixer circuit 6b, the local transmitter 7b, the PLL circuit 8b, the SAW filter 9b, the AGC amplifier 10b, and the demodulator 11b carry out the same operations as those of the first tuner 2 and the demodulator 11a.

The demultiplexer 12 can process a plurality of TSs simultaneously, and demultiplexes the TS signal 1 supplied from the demodulator 11a and the TS signal 2 supplied from the demodulator 11b into each of the video/voice/data components, and then supplies the video component having a PID (Packet ID) specified by the controller 17 to the video decoder 13 and supplies the audio component having a PID specified by the controller 17 to the audio decoder 14.

Moreover, the demultiplexer 12 acquires various kinds of tables, e.g., PAT (Program Association Table), PMT (Program Map Table), NIT (Network Information Table), SDT (Service Description Table), and the like (hereinafter, referred to as program arranging information) contained in PSI (Program Specification Information) and SI (Service Information), from the supplied TS signal, and supplies these tables to the controller 17. The channel list can be generated based on this program arranging information. The tables acquired here shall contain at least one of the tables defined by the DVB-T standard.

The video decoder 13 decodes the supplied video component to output a video signal. The digital terrestrial broadcast receiving apparatus 1 may include a video display 15, whereby the video signal output from the video decoder 13 is displayed on the video display 15. The audio decoder 14 decodes the supplied audio component to output an audio signal. The digital terrestrial broadcast receiving apparatus 1 may includes an audio output part 16, whereby the audio signal output from the audio decoder 14 is output to the voice output part 16.

Although not illustrated in FIG. 1, the digital terrestrial broadcast receiving apparatus 1 may includes a plurality of video decoders 13, whereby, for example, the video component demultiplexed from TS1, the video component being supplied from the demodulator 11a, and the video component demultiplexed from TS2, the video component being supplied from the demodulator 11b, may be decoded by the plurality of video decoders 13, respectively, to reconstruct video signals, thereby allowing for two screen displays that are divided into left and right portions on a screen of the video display 15, the display of Picture in Picture, and the like. Moreover, the video component and the audio component demultiplexed by the demultiplexer 12 may be supplied to the recording media 19. For example, while the video component and audio component demultiplexed from TS1, the video component and audio component being supplied from the demodulator 11a, are being supplied to the video decoder 13 and the audio decoder 14 and then the decoded video signal is being displayed on the video display 15 and the decoded audio signal is being output to the audio output part 16, the video component and audio component demultiplexed from TS2, the video component and audio component being supplied from the demodulator 11b, may be recorded on the storage media 19, thereby allowing the other program to be recorded.

The controller 17 controls the demodulator 11a, the demodulator 11b, the demultiplexer 12, the video decoder 13, and the audio decoder 14. Although the control lines that handle these control signals include a serial bus, a slow bus, or the like, the types of the control lines are not limited thereto in the embodiment according to the present invention. Moreover, the controller 17 prepares a channel list of receivable digital terrestrial broadcasting programs from the program arranging information supplied from the demultiplexer, and stores this list in the nonvolatile memory 18.

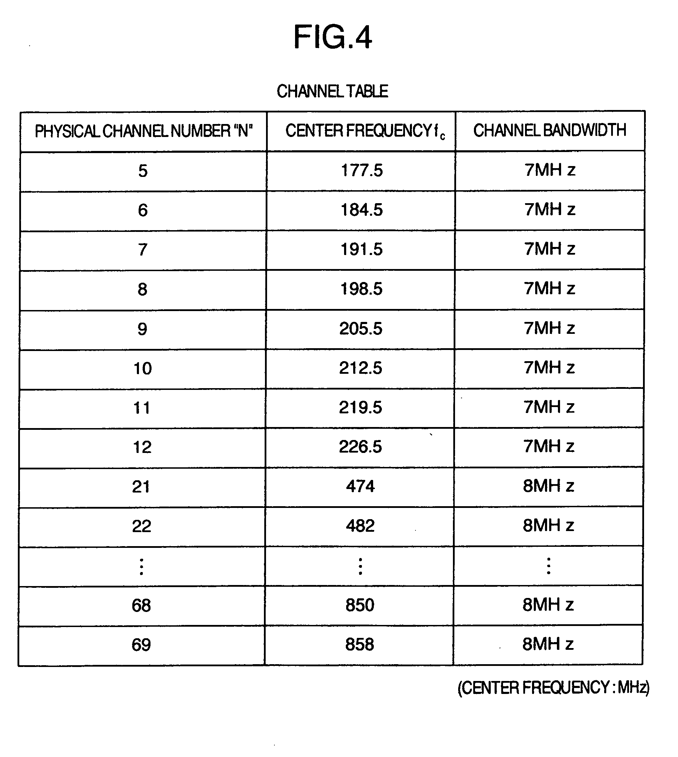

The nonvolatile memory 18 stores therein the channel list supplied from the controller 17, e.g., the table indicating a relationship between the physical channel number, the center frequency, and the channel bandwidth of each country, as show in FIG. 4, TPS information, signal quality information, a bit error rate after Viterbi decoding, and a packet error rate after RS decoding.

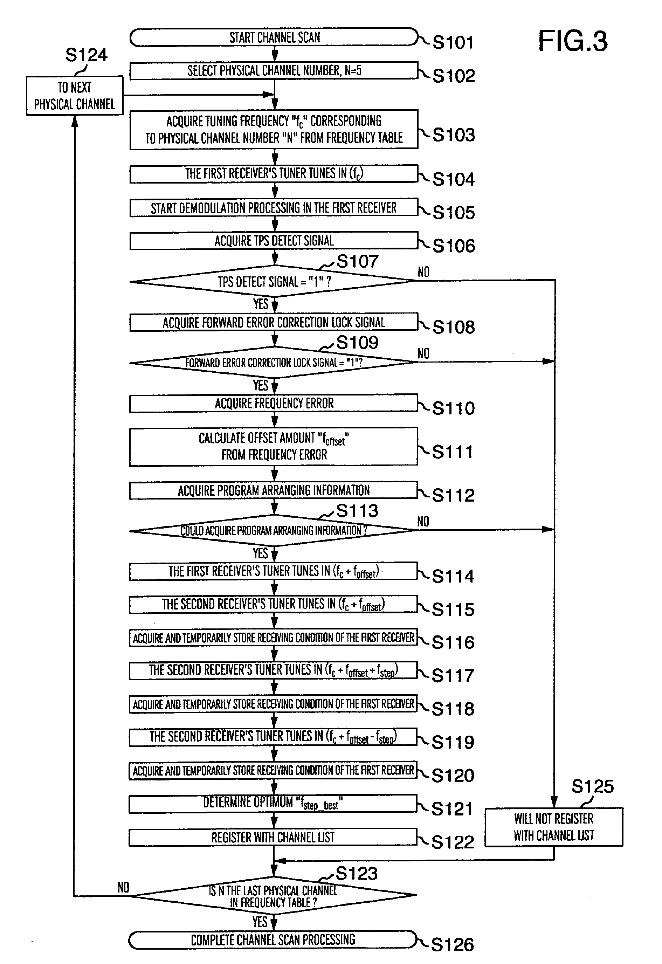

The operation in carrying out the channel list preparation function in the digital terrestrial broadcast receiving apparatus that is configured as described above will be described using FIG. 3 and FIG. 4.

FIG. 4 is an example of a table indicating a relationship between a physical channel number "N", and a center frequency as well as a channel bandwidth of digital terrestrial broadcasting, where the unit of the center frequency is in MHz. The relationship between the physical channel number and the frequency arrangement in FIG. 4 shows an example, and the relationship is not limited to the frequency arrangement shown in FIG. 4 in the embodiment according to the present invention. Moreover, the storage media for retaining this channel table is not limited in particular, however, in this embodiment, the description is made with the channel table being stored in the nonvolatile memory 18.

FIG. 3 is a flowchart for illustrating an operation example in carrying out automatic channel list preparation about the physical channel arrangement that is specified by the digital terrestrial broadcasting, in this embodiment.

First, the channel scan is started from Step S101, and the flowchart then proceeds to Step S102. In Step S102, the controller 17 selects, for example, the smallest physical channel number "N=5" out of the channel arrangement shown in FIG. 4, and then proceeds to Step S103.

In Step S103, the controller 17 acquires a tuned frequency (f_{c}) and a channel bandwidth corresponding to the physical channel number "N" from the channel table in the nonvolatile memory 18, and then proceeds to Step S104. Next, in Step S104, the controller 17 controls the first tuner 2 via the demodulator 11a so that the tuning at the tuning frequency acquired in S103 and the passband characteristic of the SAW filter 9a may be set at 7 MHz, and then proceeds to Step S105. Next, in Step S105, the controller 17 controls the demodulator 11a so as to perform the demodulation processing to the IF signal that is tuned in the first tuner 2, and then proceeds to Step S106.

In Step S106, the controller 17 acquires the TPS detect signal from the demodulator 11a, and then proceeds to Step S107. Next, in Step S107, the controller 17 determines whether or not the TPS demodulator 27 inside the demodulator 11a has been able to detect the TPS information, and then proceeds to Step S108 if it has been able to detect the TPS information (if the TPS detect signal is "1"), or proceeds to Step S125 if it has not been able to detect the TPS information yet (if the TPS detect signal is "0").

In Step S108, the controller 17 acquires an error correction lock signal from the demodulator 11a, and then proceeds to Step S109. Next, in Step S109, the controller 17 determines whether or not the error correction processing is synchronized in the forward error corrector 29 inside the demodulator 11a, and then proceeds to Step 110 if the error correction processing is synchronized (if the error correction lock signal is "1"), or proceeds to Step S125 if the error correction processing is not synchronized (if the error correction lock signal is "0").

Note that, the determination in Step S109 may be made depending on whether or not the signal quality information about the frequency domain signal supplied from the detector 28 inside the demodulator 11a exceeds a specified value, or whether or not the bit error rate in the error correction processing supplied from the forward error corrector 29 inside the demodulator 11a is below the specified value.

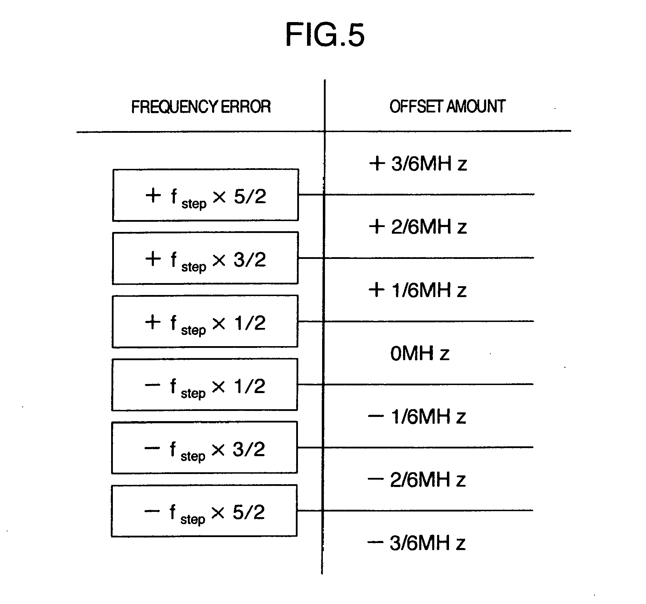

In Step S110, the controller 17 acquires a frequency error from the demodulator 11a, and then proceeds to Step S111. Next, in Step S111, the controller 17 calculates a carrier frequency offset amount (f_{offset}) of the OFDM signal from the frequency error acquired in Step S110, and then proceeds to Step S112. The calculation of the carrier frequency offset amount from the frequency error in S111 shall follow FIG. 5.

In Step S112, the controller 17 acquires program arranging information from the demultiplexer 12, and then proceeds to Step S113. Moreover, in Step S112, the controller 17 controls a time required to acquire the program arranging information so as to continue for a maximum of 10 seconds, for example,. The waiting time for this program arranging information acquisition is preferably no less than the transmission cycle of PAT having the longest transmission cycle out of the various kinds of tables contained in the program arranging information.

Next, in Step S113, the controller 17 determines whether or not it has been able to acquire the program arranging information, and then proceeds to Step S114 if it has been able to acquire a part or all of the program arranging information, or proceeds to Step S125 if it has not been able to acquire the program arranging information yet.

When the flowchart reached Step S114, it turns out that a digital broadcast wave is present in the tuned physical channel.

Next, in Step S114, the controller 17 controls the first tuner 2 via the demodulator 11a so as to tune at a frequency (f_{c} + f_{offset}), i.e., the tuned frequency (f_{c}) plus the carrier frequency offset amount acquired in S111, and then proceeds to Step S115. Here, if f_{offset} = 0, Step S114 may be omitted.

Next, in Step S115, the controller 17 controls the second tuner 3 via the demodulator 11b so as to tune at a frequency (f_{c} + f_{offset}), i.e., the tuned frequency (f_{c}) plus the carrier frequency offset amount acquired in S111, and then proceeds to Step S116. That is, in Step S115, the local oscillation frequencies of the local oscillation signals generated in the local oscillators of the first tuner 2 and the second tuner 3 are set the same.

In Step S116, the controller 17 acquires the signal quality information supplied from the detector 28 inside the demodulator 11a and the bit error rate or the packet error rate supplied from the forward error corrector 29 inside the demodulator 11a, from the demodulation controller 30, and temporarily stores these data in the nonvolatile memory 18, and then proceeds to Step S117.

Next, in Step S117, the controller 17 controls the second tuner 3 via the demodulator 11b so as to tune at a frequency (f_{c} + f_{offset} + fₛₜₑₚ), and then proceeds to Step S118. That is, in Step S117, the local oscillation frequency of the local oscillation signal generated in the local oscillator of the second tuner 3 becomes higher by fₛₜₑₚ relative to the local oscillation frequency of the local oscillation signal generated in the local oscillator of the first tuner 2.

In Step S118, the controller 17 acquires the signal quality information supplied from the detector 28 inside the demodulator 11a and the bit error rate or the packet error rate supplied from the forward error corrector 29 inside the demodulator 11a, from the demodulator 11, and temporarily stores these data, and then proceeds to Step S119.

Next, in Step S119, the controller 17 controls the second tuner 3 via the demodulator 11b so as to tune at a frequency (f_{c} + f_{offset} - fₛₜₑₚ), and then proceeds to Step S120.

That is, in Step S119, the local oscillation frequency of the local oscillation signal generated in the local oscillator of the second tuner 3 becomes lower by fₛₜₑₚ relative to the local oscillation frequency of the local oscillation signal generated in the local oscillator of the first tuner 2.

In Step S20, the controller 17 acquires the signal quality information supplied from the detector 28 inside the demodulator 11a and the bit error rate or the packet error rate supplied from the forward error corrector 29 inside the demodulator 11a, from the demodulator 11, and temporarily stores these data, and then proceeds to Step S121.

Next, in Step 121, the controller 17 compares the signal quality information as well as the bit error rate or the packet error rate acquired in S116, the signal quality information as well as the bit error rate or the packet error rate acquired in S118, and the signal quality information as well as the bit error rate or the packet error rate acquired in S120 to determine f_{step_best} that provides the best receiving condition, and then proceeds to Step 122. For f_{step_best} here, for example, f_{step_best} = 0 if the receiving condition acquired in S116 is the best, f_{step_best} = 1 if the receiving condition acquired in S118 is the best, or f_{step_best} = -1 if the receiving condition acquired in S120 is the best. Moreover, the determination of the receiving condition in this case is made using at least one of CNR, SNR, MER, BER, and PER as an index. However, not necessarily limited to the best receiving condition, but a relatively good receiving condition may be selected.

Next, in Step S122, the controller 17 controls so as to prepare a channel list based on the tuned frequency (f_{c}) that is tuned in Step S104, the frequency error (f_{offset}) acquired in Step S111, the program arranging information acquired in Step S113, and f_{step_best} that is determined in S121, and so as to store these data in the nonvolatile memory 18, and then proceeds to Step S123.

Next, in Step S123, the controller 17 determines whether or not a physical channel present in the channel table stored in the nonvolatile memory 18 has been tuned in. Then, for example, in the case where the nonvolatile memory 18 has the channel table shown in FIG. 4, if N = 69, then the controller 17 proceeds to Step S126, while if N is less than 69, then the controller 17 proceeds to Step S124 to set the next physical channel, and in this way the loop from Step S103 to Step S123 is repeated until all the physical channels are completed.

Through the above-described procedure, a channel list, including f_{step_best}, which indicates what kind of relationship the local oscillation frequencies of the first tuner 2 and the second tuner 3 should have in order for each physical channel to be in the optimum receiving condition, has been completed. However, each channel needs not strictly be the optimum, but just needs to be the optimum among the compared ones. Moreover, not necessarily limited to the optimum receiving condition among the compared ones, but each channel may be in a relatively suitable receiving condition.

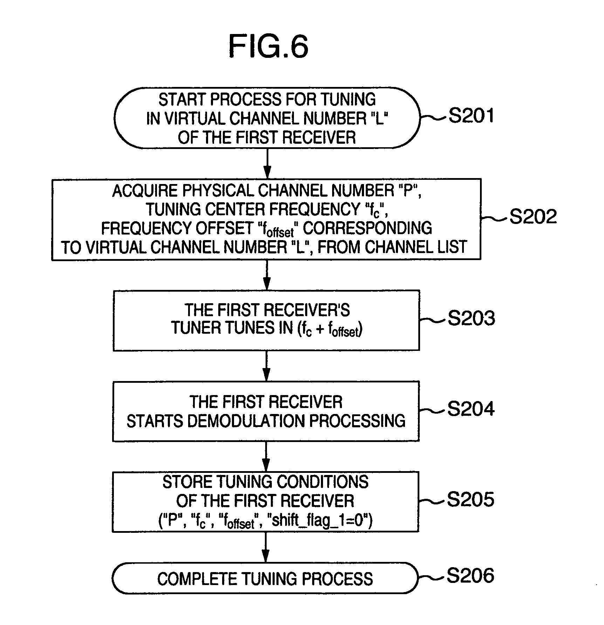

FIG. 6 is a flowchart for illustrating an example of the tuning operation when tuning is carried out for the first time after the channel scan has been completed. The term "for the first time" as used herein does not necessarily imply "for the first time as the apparatus", but implies, for example, the case where tuning is carried out "for the first time after having moved the apparatus", as well.

In S201, a process for tuning in a virtual channel number "L" in the first receiver is started by user operation, and the flowchart then proceeds to Step 202. Note that the first receiver is a generic name for the tuner 2 and the demodulator 11a of FIG. 1. Similarly, the second receiver is a generic name for the tuner 3 and the demodulator 11b of FIG. 1.

Next, in Step S202, the controller 17 acquires a physical channel number "P", the center frequency "f_{c}", and the frequency offset "f_{offset}" corresponding to the virtual channel number "L" from the channel list stored in the nonvolatile memory 18, and then proceeds to Step S203.

Next, in Step S203, the controller 17 controls the first tuner 2 via the demodulator 11a so as to tune at the frequency (f_{c} + f_{offset}) by using the center frequency "f_{c}" and the frequency offset " f_{offset} " acquired in S202, and then proceeds to Step S204.

Next, in Step S204, the controller 17 controls the demodulator 11a so as to perform the demodulation processing to the IF signal that is tuned in the first tuner 2, and then proceeds to Step S205.

Next, in Step 205, the controller 17 stores the physical channel number "P", the center frequency "f_{c}", the frequency offset "f_{offset}", and "shift_flag_1 = 0" as the current tuning condition of the first receiver into the nonvolatile memory 18, and then proceeds to Step S206 to terminate the tuning process.

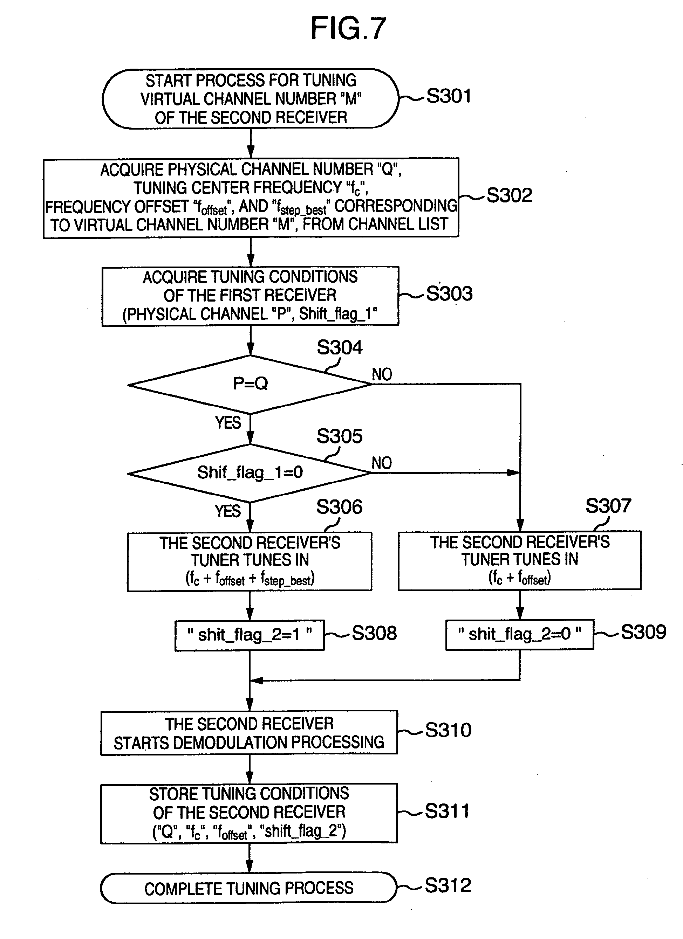

FIG. 7 is a flowchart for illustrating an operation example when the second receiver tunes while the first receiver is currently tuning in a certain physical channel. Note that, also when the first receiver tunes while the first receiver is currently tuning in a certain physical channel, the same operation example is applicable.

First, in S301, a process for tuning in a virtual channel number "M" in the second receiver is started by user operation, and then the flowchart proceeds to Step 302.

Next, in Step S302, the controller acquires a physical channel number "Q" corresponding to the virtual channel number "M", the center frequency "f_{c}", the frequency offset "f_{offset}", and "f_{step_best}, from the channel list stored in the nonvolatile memory 18, and then proceeds to Step S303.

Next, in Step S303, the controller 17 acquires the physical channel "P" and shif_flag_1 as the tuning condition of the first receiver, and then proceeds to Step S304. Next, in Step S304, the controller 17 determines whether or not the physical channel "P" which the first receiver is currently tuning in and the physical channel "Q " which the second receiver attempts to tune in are the same, and then proceeds to Step S305 if they are the same, or proceeds to Step S307 if they are not the same.

Next, in Step S305, the controller 17 determines whether or not the shift_flag_1 acquired in Step S303 is "0", and then proceeds to Step S306 if it is "0", or proceeds to Step S307 if it is not "0".

Next, in Step S306, the controller 17 controls the second tuner 3 via the demodulator 11b so as to tune at a frequency (f_{c} + foffset + f_{step_best}) by using the center frequency "f_{c}", the frequency offset "f_{offset}", and "f_{step_best}" acquired in S302, and then proceeds to Step S308. In Step S308, the controller 17 sets a shift_flag_2 to "1", and then proceeds to Step S310.

On the other hand, in Step S307, the controller 17 controls the second tuner 3 via the demodulator 11b so as to tune at the frequency (f_{c} + f_{offset}) by using the center frequency "f_{c}" and the frequency offset "f_{offset}" acquired in S302, and then proceeds to Step S309. In Step S309, the controller 17 sets the shift_flag_2 to "0", and then proceeds to Step S310.

Next, in Step S310, the controller 17 controls the demodulator 11b so as to perform the demodulation processing to the IF signal that is tuned in the second tuner 3, and then proceeds to Step S309.

Finally, in Step S311, the controller 17 stores the physical channel number "Q", the center frequency "f_{c}", the frequency offset "f_{offset}", and the "shift_flag_2" as the current tuning condition of the second receiver into the nonvolatile memory 18, and then proceeds to Step S310 to terminate the tuning process.

As described above, according to this embodiment, it is possible to provide a receiving apparatus with a plurality of tuners and a method of controlling the same which, even under environment where an analog broadcasting signal and a digital broadcasting signal are being transmitted to an adjacent physical channel in the receiving apparatus with a plurality of tuners, can minimize the influence of the interfering wave and maintain the optimum receiving condition.

In the above-described embodiment, the details of the operation in DVB-T, which is the digital terrestrial broadcasting system in Europe, have been described, however, similar effects can be obtained also in other broadcast systems.

## Claims

1. A receiving apparatus (1), comprising:
a first receiver (2, 11a) for frequency-converting a received signal;
a second receiver (3, 11b) for frequency-converting the received signal; and
a controller (17) that controls so as to switch a parameter for converting a corresponding frequency depending on when the first receiver (2, 11a) and the second receiver (3, 11b) commonly received a signal having a first frequency, respectively, and when the receivers ((2, 11a), (3, 11b)) commonly received a signal having a second frequency, respectively.

2. The receiving apparatus (1) according to claim 1, wherein the controller (17) determines the parameter for converting a corresponding frequency, by switching the parameter and comparing a result thereof.

3. A receiving apparatus (1), comprising:
a first receiver (2, 11a) for frequency-converting a received signal;
a second receiver (3, 11b) for frequency-converting the received signal; and
a controller (17) which controls, when the first receiver (2, 11a) and the second receiver (3, 11b) commonly received a signal having a first frequency, respectively, so as to make a parameter for converting the first frequency different between in the first receiver (2, 11a) and in the second receiver (3, 11b), and which further controls, when the first receiver (2, 11a) and the second receiver (3, 11b) received a signal having a second frequency different from the first frequency, so as to make a parameter for converting the second frequency common between in the first receiver (2, 11a) and in the second receiver (3, 11b).

4. The receiving apparatus (1) according to claim 3, wherein the controller (17) determines whether to make the parameter different or to make the parameter common by switching the parameter and comparing a result thereof.

5. A receiving apparatus (1), comprising:
a splitter (5) that splits an RF signal of digital terrestrial broadcasting transmitted from a broadcasting station into at least two signals;
a local oscillator (7a, 7b) that generates a local oscillation signal at a specified frequency interval (fₛₜₑₚ [MHz]);
a tuner (2, 3) that frequency-converts a signal of a desired physical channel into an IF signal by multiplying an RF signal, the RF signal being a signal split by the splitter (5), by the local oscillation signal generated by the local oscillator (7a, 7b);
a demodulator (11a, 11b), having a signal quality acquisition part (30) that acquires a quality of a received signal, that digitally demodulates the IF signal, the IF signal being a signal frequency-converted by the tuner (2, 3); and
a controller (17) that controls the local oscillator (7a, 7b), the tuner (2, 3), and the demodulator (11a, 11b)
the receiving apparatus (1) including a plurality of the local oscillators (7a, 7b), the tuners (2, 3), and the demodulators (11a, 11b), respectively, wherein
in the case where physical channels that are frequency-converted by at least two tuners (2, 3) among the plurality of tuners are the same, the controller (17) controls,
when, with respect to a local oscillation frequency generated by one of the plurality of local oscillators (7a, 7b), a local oscillation frequency generated by other local oscillator is the same, and when the local oscillation frequency generated by other local oscillator (7b, 7a) is shifted by ± m × fₛₜₑₚ [MHz] (m is an integer), respectively,
so as to compare the signal quality information acquired by a plurality of the signal quality acquisition parts (30) and calculate frequencies of the local oscillation signals generated by the plurality of local oscillators (7a, 7b) so that receiving condition in the plurality of demodulators (11a, 11b) may be the best.

6. The receiving apparatus (1) according to claim 5, wherein the demodulator (11a, 11b) comprises:
an analog to digital converter (21) for converting the IF signal, the IF signal being a signal frequency-converted by the tuner (2, 3), into a digital signal;
a quadrature demodulator (22) for quadrature demodulating the digital signal, the digital signal being a signal converted by the analog to digital converter (21), into a baseband signal;
an FFT operation part (24) for converting the baseband signal, the baseband signal being a signal quadrature demodulated by the quadrature demodulator (22), into a frequency domain signal by FFT operation;
a detector (28) for detecting a frequency domain signal, the frequency domain signal being a signal converted by the FFT operation part (24), and thereby decoding data; and
a forward error corrector (29) for correcting an error of the data that is decoded by the detector (28).

7. The receiving apparatus (1) according to claim 6, wherein the signal quality information acquired by the signal quality acquisition part (30) is at least one of a carrier to noise ratio (CNR), a signal to noise ratio (SNR), and a modulation error ratio (MER) that are detected in the detector (28).

8. The receiving apparatus (1) according to claim 6, wherein the signal quality information acquired by the signal quality acquisition part (30) is at least one of a bit error rate (BER) and a packet error rate (PER) that are detected in the forward error corrector (29).

9. The receiving apparatus (1) according to any one of claims 1 to 4, further comprising;
a demultiplexer (12) for demultiplexing the data that is digitally demodulated by the plurality of demodulators (11a, 11b);
a video decoder (13) for decoding a video component that is demultiplexed by the demultiplexer (12); and
an audio decoder (14) for decoding an audio component that is demultiplexed by the demultiplexer (12).

10. The receiving apparatus (1) according to claim 9, further comprising a video display (15) for displaying a video signal that is decoded by the video decoder (13).

11. The receiving apparatus (1) according to claim 9, further comprising an audio output part (16) for outputting an audio signal that is decoded by the audio decoder (14).

12. A method of preparing a channel list in a receiving apparatus (1) with a plurality of receivers ((2, 11a), (3, 11b)), the method comprising:
a minimum physical channel selection step of selecting a minimum physical channel number present in a channel table;
a tuning frequency selection step of selecting a tuning frequency corresponding to the minimum physical channel number;
a first tuning step of tuning a signal having a tuning frequency selected in a first receiver (2, 11a) among the plurality of receivers ((2, 11a), (3, 11b));
a digital broadcast receiving step of performing digital demodulation and error correction processing on the signal that is tuned in the first receiver (2, 11a); and
a digital broadcast determination step of determining whether or not a digital broadcasting signal is contained in the signal tuned in the first receiver (2, 11a), the method further comprising:
when, in the digital broadcast determination step, a digital terrestrial broadcasting signal is contained in the selected physical channel;
a second tuning step of tuning in a signal having a tuning frequency that is selected in a second receiver (3, 11b) among the plurality of receivers ((2, 11a), (3, 11b));
a first receiving condition acquisition step of acquiring a receiving condition of a digital broadcast that is being received in the first receiver (2, 11a);
a third tuning step of tuning by shifting one step from the tuning frequency that is selected in the second receiver (3, 11b);
a second receiving condition acquisition step of acquiring a receiving condition of a digital broadcast that is being received in the first receiver (2, 11a);
a receiving condition comparison step of comparing a receiving condition acquired in the first receiving condition acquisition step with a receiving condition acquired in the second receiving condition acquisition step;
a tuning frequency determination step of determining a tuning frequency suitable as a tuning frequency of the second receiver (3, 11b) from a comparison result in the receiving condition comparison step; and
a channel list registration step of associating and registering the tuning frequency and the physical channel number that are determined in the tuning frequency determination step.
